(19) Europäisches Patentamt
European Patent Office
Office européen des brevets

(11) **EP 4 733 794 A1**

(12) **EUROPÄISCHE PATENTANMELDUNG**

(43) Veröffentlichungstag:
**29.04.2026 Patentblatt 2026/18**

(21) Anmeldenummer: **24208862.3**

(22) Anmeldetag: **25.10.2024**

(51) Internationale Patentklassifikation (IPC):
**G01R 33/389** (2006.01)  **G01R 33/565** (2006.01)
**G01R 33/54** (2006.01)

(52) Gemeinsame Patentklassifikation (CPC):
**G01R 33/389; G01R 33/56563;** G01R 33/543

(84) Benannte Vertragsstaaten:
**AL AT BE BG CH CY CZ DE DK EE ES FI FR GB GR HR HU IE IS IT LI LT LU LV MC ME MK MT NL NO PL PT RO RS SE SI SK SM TR**
Benannte Erstreckungsstaaten:
**BA**
Benannte Validierungsstaaten:
**GE KH MA MD TN**

(71) Anmelder: **Siemens Healthineers AG**
**91301 Forchheim (DE)**

(72) Erfinder: **POPESCU, Stefan**
**91056 Erlangen (DE)**

(74) Vertreter: **Siemens Healthineers**
**Patent Attorneys**
**Postfach 22 16 34**
**80506 München (DE)**

(54) **VERFAHREN ZUM BETRIEB EINER MAGNETRESONANZEINRICHTUNG, ZUGEHÖRIGES SYSTEM, ZUGEHÖRIGE STEUERUNGSEINRICHTUNG UND ZUGEHÖRIGE SPEICHEREINHEIT**

(57)    Die Erfindung betrifft ein Verfahren zum Betrieb einer Magnetresonanzeinrichtung (10), wobei mittels der Magnetresonanzeinrichtung (10) eine Bildgebung zur Erfassung von Bilddaten (11) durchführbar ist, die ein Objekt (13) betreffen, das in einem Aufnahmebereich (12) der Magnetresonanzeinrichtung (10) angeordnet ist, wobei zur Durchführung der Bildgebung die folgenden Schritte ausgeführt werden:
(i) Erzeugung eines in dem Aufnahmebereich (12) vorliegenden Einrichtungsmagnetfeldes (23) mittels einer Magneteinrichtung (20) der Magnetresonanzeinrichtung (10), wobei ein tatsächlich in dem Aufnahmebereich (12) vorhandenes, gestörtes Magnetfeld aus dem Einrichtungsmagnetfeld (23) und wenigstens einem Störfeld (33) resultiert, wobei das Störfeld (33) von einem sich außerhalb des Aufnahmebereichs (12) befindenden Störobjekt (35) verursacht wird,
(ii) Erfassen wenigstens einer Messinformation (38) mittels wenigstens eines Magnetsensors (30), wobei die Messinformation (38) ein außerhalb des Aufnahmebereichs (12) vorliegendes und aus dem Einrichtungsmagnetfeld (23) und dem wenigstens einen Störfeld (33) resultierendes Streumagnetfeld betrifft,
(iii) Ermitteln wenigstens einer Störinformation (40) betreffend das wenigstens eine Störfeld (33) unter Verwendung der wenigstens einen Messinformation (38),
(iv) Kompensieren oder Reduzieren des wenigstens einen Störfeldes (33) in dem Aufnahmebereich (12) mittels einer Änderung des Einrichtungsmagnetfeldes (23) unter Verwendung der wenigstens einen Störinformation (40),
wobei in Schritt (iii) zum Ermitteln der wenigstens einen Störinformation (40) eine Modellierung des wenigstens einen Störfeldes (33) unter Verwendung der wenigstens einen Messinformation (38) erfolgt, wobei zur Modellierung ein ein Vektorfeld beschreibendes Feldmodell für das wenigstens eine Störfeld (33) verwendet wird.

FIG 4

**Beschreibung**

Die vorliegende Erfindung betrifft ein Verfahren zum Betrieb einer Magnetresonanzeinrichtung, wobei mittels der Magnetresonanzeinrichtung eine Bildgebung zur Erfassung von Bilddaten durchführbar ist, die ein Objekt betreffen, das in einem Aufnahmebereich der Magnetresonanzeinrichtung angeordnet ist, wobei zur Durchführung der Bildgebung die folgenden Schritte ausgeführt werden:

(i) Erzeugung eines in dem Aufnahmebereich vorliegenden Einrichtungsmagnetfeldes mittels einer Magneteinrichtung der Magnetresonanzeinrichtung, wobei ein tatsächlich in dem Aufnahmebereich vorhandenes, gestörtes Magnetfeld aus dem Einrichtungsmagnetfeld und wenigstens einem Störfeld resultiert, wobei das Störfeld von einem sich außerhalb des Aufnahmebereichs befindenden Störobjekt verursacht wird,
(ii) Erfassen wenigstens einer Messinformation mittels wenigstens eines Magnetsensors, wobei die Messinformation ein außerhalb des Aufnahmebereichs vorliegendes und aus dem Einrichtungsmagnetfeld und dem wenigstens einen Störfeld resultierendes Streumagnetfeld betrifft,
(iii) Ermitteln wenigstens einer Störinformation betreffend das wenigstens eine Störfeld unter Verwendung der wenigstens einen Messinformation,
(iv) Kompensieren oder Reduzieren des wenigstens einen Störfeldes in dem Aufnahmebereich mittels einer Änderung des Einrichtungsmagnetfeldes unter Verwendung der wenigstens einen Störinformation.

Magnetresonanzeinrichtungen werden zur Durchführung von Bildgebungen mittels des Magnetresonanztomografieverfahrens, die häufig auch als Kernspintomografieverfahren bezeichnet werden, eingesetzt. Ein zentrales, diesbezügliches Anwendungsgebiet betrifft die medizinische Bildgebung, wobei mittels Magnetresonanzeinrichtungen beispielsweise krankhafte Veränderungen im Körper, insbesondere Tumore, erkannt werden können. Hierzu wird das Körperinnere des Objekts, also des Patienten, unter Einsatz von hohen Magnetfeldern Schicht für Schicht sichtbar gemacht.

Zur Durchführung der Bildgebung werden Kernspins des Untersuchungsobjektes mittels eines starken äußeren Magnetfeldes, das oft auch als Hauptmagnetfeld bezeichnet wird, ausgerichtet und mittels eines magnetischen Wechselfeldes zur Präzession um diese Ausrichtung angeregt. Die Präzession beziehungsweise Rückkehr der Spins aus diesem angeregten Zustand in einen Zustand mit geringerer Energie wiederum erzeugt als Antwort ein magnetisches Wechselfeld, das über Antennen empfangen wird.

Konkret wird in einem Aufnahmebereich der Magnetresonanzeinrichtung, in der das zu untersuchende Objekt beziehungsweise der Patient angeordnet ist, das Hauptmagnetfeld mittels der Magneteinrichtung erzeugt. Weiterhin wird mittels der Magneteinrichtung im Aufnahmebereich ein Gradientenfeld erzeugt, das eine im Zuge der Durchführung der Bildgebung erforderliche Positionsbestimmung im Aufnahmebereich ermöglicht. Mittels des Hauptmagnetfeldes erfolgt eine Ausrichtung der Spins der Atomkerne der Wasserstoff-Atome im Körper, wobei anschließend ein kurzer Hochfrequenzimpuls respektive Radiowellen mittels einer Hochfrequenzantenneneinheit erzeugt wird respektive werden, was dazu führt, dass sich die Ausrichtung der Atomkerne kurzzeitig ändert und hierdurch das magnetische Wechselfeld entsteht, wobei die entsprechend entstehenden Signale, die im Zuge der Bildgebung genutzt werden, sich von der Art des jeweiligen Gewebes unterscheiden. Mit Hilfe der Gradientenfelder wird den Signalen eine Ortskodierung aufgeprägt, die nachfolgend eine Zuordnung von dem empfangenen Signal zu einer Position innerhalb des Aufnahmebereichs ermöglicht. Das empfangene Signal wird dann ausgewertet und eine dreidimensionale Darstellung des Untersuchungsobjektes bereitgestellt. Zum Empfang des Signals werden vorzugsweise lokale Empfangsantennen, sogenannte Lokalspulen, der Hochfrequenzantenneneinheit verwendet. Der Aufnahmebereich, der zumeist kugelförmig beziehungsweise sphärisch ausgebildet ist und auch als "field of view" (FoV) der Magnetresonanzeinrichtung bezeichnet werden kann, befindet sich typischerweise innerhalb eines Patiententunnels der Magnetresonanzeinrichtung.

Problematisch hierbei sind Störungen des im Aufnahmeraum vorliegenden Magnetfeldes, die die Bildgebung beeinträchtigen können. Zu nennen sind diesbezüglich einerseits Abweichungen dieses Magnetfeldes von einem idealen, homogenen Feld. Andererseits können Störungen durch sich nahe am Aufnahmeraum bewegende, ferromagnetische Objekte verursacht werden, etwa vorbeifahrende Kraftfahrzeuge, Aufzüge, Straßen- oder U-Bahnen. Die Berücksichtigung respektive Unterdrückung derartige Störungen ist erforderlich, um Bildartefakte wie beispielsweise Signallücken, Fettsättigungsfehler oder geometrische Bildverzerrungen zu vermeiden. Besonders anfällig hierfür sind sogenannte Niederfeld-Scanner, die mit Magnetfeldstärken des Hauptmagnetfeldes von höchstens circa 0,5 Tesla arbeiten.

Um diesem Problem zu begegnen, wurde die Verwendung einer supraleitenden Spule zur Unterdrückung dieser Störungen vorgeschlagen, mittels der durch externe Magnetfelder verursachte Magnetfeldverschiebungen ausgeglichen werden. Der zugehörige, passiv arbeitende Schaltkreis reagiert jedoch typischerweise recht langsam, was problematisch bezüglich einer effektiven Unterdrückung der Störungen ist. Weiterhin wird hierdurch lediglich eine konstante Verschiebung der Magnetfeldstärke des Hauptmagnetfeldes kompensiert, wobei häufig auch eine Kompensation bezüglich der Anteile höherer Ordnung wünschenswert wäre.

Eine weitere denkbare Vorgehensweise zur Unterdrückung dieser externen Störungen ist in EP 4 369 017 A1 beschrieben. Demnach erfolgt eine Messung der Magnetfeldstärke, wobei eine sogenannten Transferfunktion, die den Zusammenhang zwischen dem Magnetfeld am Sensor und dem Aufnahmebereich vorgibt, bestimmt wird. Eine Kalibrierung einer Zeitkomponente der Übertragungsfunktionen erfolgt unter Verwendung einer Impulsanregung, die mittels einer an einen bestimmten Ort und unter einer bestimmten Ausrichtung angeordneten Störquelle, nämlich einer Kalibrierspule, erzeugt wird. Für die Kalibrierung der Übertragungsfunktionen im räumlichen Bereich wäre es jedoch erforderlich, eine solche Anregung beziehungsweise solche Eingangssignale bereitzustellen, die alle möglichen Orte und Ausrichtungen einer externen magnetischen Störquelle abdeckt beziehungsweise abdecken. In der Praxis ist die Durchführung einer solchen Kalibrierung schwierig und zeitaufwändig, wobei die vorliegende Erfindung eine diesbezügliche Lösung respektive Verbesserung realisiert.

Ein weiteres Konzept bezüglich der Bestimmung eines mittels einer Magnetresonanzeinrichtung erzeugten Magnetfeldes ist in EP 4 105 671 A1 respektive US 11 953 572 B2 beschrieben. Hierbei ist vorgesehen, dass mehrere Magnetvektoren an verschiedenen Stellen des Magnetfeldes mittels einer Magnetfeldsensoreinheit erfasst werden, wobei jeder der Magnetvektoren einen Betrag und eine Richtung des Magnetfeldes an der jeweiligen Stelle beschreibt. Die Ermittlung des Magnetfeldes erfolgt dadurch, dass anhand der Magnetvektoren ein Modell eines Vektorfeldes ermittelt wird.

Als weiterer technologischer Hintergrund ist die Druckschrift US 11 815 575 B2 zu nennen. Diese Druckschrift offenbart eine Magnetresonanz-Bildgebungsvorrichtung mit einer Hauptfeldeinheit zum Generieren eines Hauptmagnetfeldes, einer Gradientenspulenanordnung zum Generieren eines Gradientenfeldes, einer Hochfrequenzanordnung zum Senden von Anregungssignalen und zum Empfangen von Magnetresonanzsignalen, einer Sensoreinrichtung zur Bestimmung von Magnetfeldinformationen in einem Abbildungsbereich, wobei die Sensoreinrichtung mehrere Magnetfeldsensoren im Abbildungsbereich umfasst. Anhand der Sensordaten wird eine Magnetfeldinformation für den Abbildungsbereich berechnet, wobei in Abhängigkeit von der Magnetfeldinformation eine Kalibrierungs- beziehungsweise Korrekturmaßnahme durchgeführt wird.

Die vorliegende Erfindung stellt sich die Aufgabe, ein verbessertes Konzept bezüglich der Kompensation von in dem Aufnahmeraum vorhandenen Magnetfeldstörungen anzugeben.

Erfindungsgemäß gelöst wird diese Aufgabe bei einem Verfahren der eingangs genannten Art dadurch, dass in Schritt (iii) zum Ermitteln der wenigstens einen Störinformation eine Modellierung des wenigstens einen Störfeldes unter Verwendung der wenigstens einen Messinformation erfolgt, wobei zur Modellierung ein ein Vektorfeld beschreibendes Feldmodell für das wenigstens eine Störfeld verwendet wird.

Die Erfindung beruht insbesondere auf dem Gedanken, dass anhand der Messinformation Rückschlüsse bezüglich des in dem Aufnahmebereich tatsächlich vorhandenen Magnetfeldes gezogen werden können, was wiederum die Ermittlung der Störinformation erlaubt, die wiederum konkret auf das in dem Aufnahmebereich vorliegende Störfeld gerichtet ist und zu dessen Kompensation oder zumindest Reduktion, also zur teilweisen Kompensation, genutzt werden kann.

Die im Rahmen des Schritts (i) vorgesehene Erzeugung des Einrichtungsmagnetfeldes erfolgt mittels der Magneteinrichtung. Die Magneteinrichtung umfasst wenigstens eine, insbesondere supraleitende, Spule, mittels der ein Magnetfeld mit zumindest näherungsweise parallelen Feldlinien im Aufnahmebereich erzeugt wird. Das stets vorliegende Erdmagnetfeld kann als eine Komponente respektive ein Anteil des Einrichtungsmagnetfeldes verstanden werden. Da sich das Einrichtungsmagnetfeld nicht nur auf den Aufnahmebereich beschränkt, sondern sich auch außerhalb des Aufnahmebereichs beziehungsweise der Magnetresonanzeinrichtung erstreckt, bewirkt dieses bei ferromagnetischen Objekten, die sich in dem Einflussbereich dieses Magnetfeldes befinden, ein entsprechendes Gegenfeld, das wiederum eine Änderung des in dem Aufnahmebereich tatsächlich vorliegenden Magnetfeldes bewirkt, sodass sich dieses von dem eigentlich gewollten Einrichtungsmagnetfeld unterscheidet.

So wird in Schritt (ii) die Messinformation erfasst, die das Streumagnetfeld außerhalb des Aufnahmebereichs beziehungsweise der Magnetresonanzeinrichtung betrifft, wobei das Streumagnetfeld aus dem Einrichtungsmagnetfeld einerseits und dem Störfeld andererseits resultiert. Zur Erfassung der Messinformation werden Messsignale des Magnetsensors erfasst und ausgewertet beziehungsweise verarbeitet, wobei mittels des Magnetsensors bevorzugt ein jeweiliger an dem Ort des Magnetsensors vorliegender Magnetfeldvektor oder, kurz, Magnetvektor erfasst wird. Mittels des Magnetsensors kann mithin ein Betrag und eine Richtung des Streumagnetfeldes ermittelt werden. Mittels des Magnetsensors können drei Zahlenwerte erfasst werden, die jeweils einen Betrag des Streumagnetfeldes entlang einer der drei kartesischen Raumrichtungen angeben. Der Magnetsensor gemäß dieser Ausführung kann als ein Vektormagnetometer bezeichnet werden. Die in der bereits eingangs genannten Druckschrift EP 4 369 017 A1 erläuterten Aspekte bezüglich der dort vorgesehenen Magnetfeldsensoren sind analog auf den wenigstens einen Magnetsensor, der bei der vorliegenden Erfindung vorgesehen ist, übertragbar.

In Schritt (iii) wird die Störinformation anhand der Messinformation bestimmt. Hierbei ist erfindungsgemäß die Durchführung einer mathematischen Modellierung des Störfeldes unter Verwendung der Messinformation vorgesehen.

Diese Modellierung beruht insbesondere auf dem Umstand beziehungsweise dem Ansatz, dass bezüglich des Störfeldes eine Quellenfreiheit betreffend zumindest den Aufnahmebereich gegeben ist. Das bedeutet, dass das Störfeld seitens der Magnetresonanzeinrichtung, die hauptsächlich aus nicht-ferromagnetischen Werkstoffen besteht, keine elektrischen Ströme induziert und dort mithin auch keine magnetischen Dipole, also Quellen, durch das Störfeld verursacht werden. Für das das Störfeld beschreibende Feldmodell, für das vorliegend ein Vektorfeld verwendet wird, folgt somit, dass dessen Divergenz sowie dessen Rotation Null ergibt. Ferner folgt, dass es sich bei dem Störfeld um ein sogenanntes harmonisches Vektorfeld handelt, für das die sogenannte Laplace-Gleichung gilt, gemäß der die Anwendung des Laplace-Operators auf das das Störfeld beschreibende Vektorfeld den Wert Null ergibt. Dieser Ausgangspunkt ermöglicht eine vereinfachte numerische respektive rechnerische Handhabung der Mess- und/oder Störinformation, etwa betreffend mögliche Lösungsansätze zur Ermittlung der wenigstens einen Störinformation. So können hierzu, wie später noch im Detail erläutert werden wird, bekannte Lösungen für die Laplace-Gleichung zugrundegelegt werden, sodass zur Bestimmung der wenigstens einen Störinformation insbesondere nur noch ein lineares Gleichungssystem zu lösen oder ein Fit durchzuführen ist.

Im Schritt (iv) des Verfahrens erfolgt insbesondere eine Anpassung wenigstens eines zur Durchführung der Bildgebung verwendeten Durchführungsparameters, wobei diese Anpassung wiederum das Kompensieren oder Reduzieren des Störfeldes in dem Aufnahmebereich bewirkt. So hängen Parameter des Einrichtungsmagnetfeldes von den Durchführungsparameters ab, die gezielt anhand der Störinformation derart geändert beziehungsweise modifiziert werden, sodass das tatsächlich in dem Aufnahmeraum vorliegende Magnetfeld, dass aus dem geänderten Einrichtungsmagnetfeld sowie dem wenigstens einen Störfeld resultiert, dem eigentlich gewünschten Magnetfeld in dem Aufnahmeraum entspricht. Konkret können die Durchführungsparameter zunächst derart vorgegeben werden, dass das resultierende, tatsächliche Magnetfeld im Aufnahmebereich dem eigentlich gewünschten Magnetfeld bei Abwesenheit des Störfeldes entspricht, wobei die anhand der wenigstens einen Störinformation erfolgende Änderung der Durchführungsparameters eine Änderung des Einrichtungsmagnetfeldes derart bewirkt, dass dieses zusammen mit dem wenigstens einen Störfeld zum Auftreten des gewünschten Magnetfeldes in dem Aufnahmebereich führt. Hierzu kann ein iteratives Vorgehen vorgesehen sein.

Das Durchführen der Schritte des erfindungsgemäßen Verfahrens, insbesondere das Erfassen und Auswerten der wenigstens einen Messinformation und gegebenenfalls die simultan hierzu erfolgende Erfassung der Bilddaten, erfolgt bevorzugt kontinuierlich oder zyklisch in vorbestimmten Zeitintervallen, sodass das Kompensieren oder Reduzieren des Störfeldes in dem Aufnahmebereich in Echtzeit erfolgt. Dies ist deshalb vorteilhaft, da Quellen des Störfeldes, die auch als Störobjekte bezeichnet werden und beispielsweise Fahrzeuge oder Aufzüge sein können, sich entlang einer Trajektorie bewegen können, sodass sich ihre Relativposition bezüglich der Magnetresonanzeinrichtung typischerweise über die Zeit und während der Durchführung der Bildgebung ändern, was wiederum eine Änderung des Störfeldes über die Zeit zur Folge hat.

Bevorzugt umfasst die Magneteinrichtung wenigstens eine Hauptfeldspule und wenigstens eine Gradientenspulenanordnung, wobei in Schritt (i) in dem Aufnahmebereich ein Hauptmagnetfeld mittels der wenigstens einen Hauptfeldspule und wenigstens ein Gradientenfeld mittels der wenigstens einen Gradientenspulenanordnung erzeugt wird. Das Hauptmagnetfeld ist bevorzugt, bezogen auf dem Aufnahmebereich, wenigstens näherungsweise homogen und umfasst mithin zumindest näherungsweise parallel verlaufende Feldlinien. Zudem bewirkt das Gradientenfeld einen, bevorzugt linearen, Anstieg der Magnetfeldstärke bezüglich einer Raumrichtung und somit einen Feldgradienten, wodurch im Rahmen der Bildgebung eine Orts- respektive Positionsbestimmung innerhalb des Aufnahmebereichs ermöglicht wird. Hierbei können drei Gradientenspulenanordnungen vorgesehen sein, sodass bezüglich jeder der, insbesondere kartesischen, Raumrichtungen ein Feldgradient erzeugt wird. Eine Hochfrequenzantenneneinheit der Magneteinrichtung kann für die Generierung des Hochfrequenzimpulses respektive der Radiowellen vorgesehen sein.

Wie bereits weiter oben angesprochen wurde, kann in Schritt (ii) mittels des Magnetsensors oder mittels jedem der Magnetsensoren die einen Magnetvektor darstellende Messinformation erfasst werden. Das bedeutet, dass mit der Erfassung der Messinformation sowohl ein Betrag als auch eine Richtung des an dem Ort des jeweiligen Magnetsensors vorliegenden Magnetfeldes ermittelt wird. Konkret kann der Magnetvektor drei, insbesondere skalare, Werte umfassen, die jeweils die Stärke des Streumagnetfeldes bezüglich einer kartesischen Raumrichtung betreffen. Eine Sensitivität des Magnetsensors ist bevorzugt hinreichend hoch, sodass Messwerte betreffend das Streumagnetfeld hinsichtlich einer Auflösung erfassbar sind, die unterhalb einer Amplitude des typischerweise vorliegenden Störfeldes liegt.

Denkbar ist, dass der wenigstens eine in Schritt (ii) verwendete Magnetsensor an einer Wand oder einer Decke oder einem Fußboden eines Raumes, in dem sich die Magnetresonanzeinrichtung befindet, angeordnet ist. Denkbar ist, dass mehrere Magnetsensoren an den Ecken eines, insbesondere regelmäßigen, Polyeders angeordnet sind, insbesondere an den Ecken eines Quaders. Der Polyeder kann die Geometrie des Raumes aufweisen, in dem sich die Magnetresonanzeinrichtung befindet. Besonders bevorzugt sind die Magnetsensoren in den Ecken dieses Raumes angeordnet. Insbesondere im Falle eines quaderförmigen Raumes können insgesamt zumindest oder genau acht Magnetsensoren verwendet werden.

Bevorzugt ist erfindungsgemäß vorgesehen, dass in Schritt (iii) anhand der wenigstens einen Messinformation wenigstens eine bereinigte Messinformation ermittelt wird, die das außerhalb des Aufnahmebereichs vorliegende und bezüglich des Einrichtungsmagnetfeldes bereinigte Streumagnetfeld betrifft. Hierbei können bekannte Parameter betreffend das Einrichtungsmagnetfeld zur Durchführung der Bereinigung der wenigstens einen Messinformation verwendet werden. Folglich betrifft die bereinigte Messinformation nicht mehr das Streumagnetfeld, also das Einrichtungsmagnetfeld und das Störfeld, sondern nur noch das Störfeld. Hierzu können die Werte betreffend das bekannte Einrichtungsmagnetfeld als eine Einrichtungsinformation vorliegen. Die Einrichtungsinformation kann einen Magnetvektor umfassen, betreffend zumindest die Position des wenigstens einen Magnetsensors. Der Magnetvektor kann drei, bevorzugt skalare, Werte umfassen, die jeweils die Stärke des Einrichtungsmagnetfeldes bezüglich einer kartesischen Raumrichtung betreffen. Die Ermittlung der wenigstens einen bereinigten Messinformation bewirkt eine Vereinfachung der weiteren Verarbeitung der bereinigten Messinformation.

Im Rahmen einer denkbaren Weiterbildung kann vorgesehen sein, dass zur Ermittlung der wenigstens einen bereinigten Messinformation Werte betreffend das bekannte Einrichtungsmagnetfeld von Werten betreffend das Streumagnetfeld, die anhand der wenigstens einen Messinformation vorliegen, subtrahiert werden. Diesem Vorgehen liegt bezüglich des Streumagnetfeldes das Superpositionsprinzip respektive die Superpositionstheorie zu Grunde. Hierzu wird davon ausgegangen, dass das Einrichtungsmagnetfeld aufgrund der ferromagnetischen Eigenschaften des Störobjektes ein magnetisches Moment in dem Störobjekt bewirkt, wobei das Störfeld durch dieses magnetische Moment verursacht wird. Somit ergibt sich das Streumagnetfeld aus einer Vektorsumme betreffend das das Einrichtungsmagnetfeld beschreibende Vektorfeld und das das Störfeld beschreibende Vektorfeld. Da das das Einrichtungsmagnetfeld beschreibende Vektorfeld typischerweise bekannt ist, führt eine Subtraktion, bei der quasi das Einrichtungsmagnetfeld von dem Streumagnetfeld abgezogen wird, zu dem das Störfeld beschreibenden Vektorfeld.

Nun sei angenommen, dass als die wenigstens eine Messinformation der an der Position des jeweiligen Magnetsensors vorliegende Magnetvektor erfasst wurde, der drei skalare Werte umfasst, wobei jeder dieser Werte die Stärke des Streumagnetfeldes bezüglich einer der drei kartesischen Raumrichtung betrifft. Ferner sei angenommen, dass die Werte betreffend das bekannte Einrichtungsmagnetfeld als die bereits genannte Einrichtungsinformation vorliegen. Als die Einrichtungsinformation liegt wenigstens ein Magnetvektor betreffend die Position des wenigstens einen Magnetsensors vor, der drei skalare Werte umfasst, wobei jeder dieser Werte die Stärke des Einrichtungsmagnetfeldes bezüglich einer der drei kartesischen Raumrichtungen betrifft. Die Subtraktion erfolgt sodann bevorzugt im Rahmen einer Vektorsubtraktion, bei der bezüglich jeder Raumrichtung die Magnetfeldstärke des Einrichtungsmagnetfeldes von der Magnetfeldstärke des Streumagnetfeldes abgezogen wird.

Bezüglich des Schritts (iii) ist, wie bereits weiter oben angesprochen wurde, denkbar, dass das Feldmodell ein harmonisches Vektorfeld beschreibt. Zudem kann das Feldmodell auf einer Funktionsentwicklung beruhen, die räumlich harmonische Basisfunktionen umfasst. Räumlich harmonische Basisfunktionen werden oft auch als "spatial harmonics" bezeichnet und sind bezüglich des dreidimensionalen, kartesischen Raums definiert. Zur Approximation des Störfeldes wird bevorzugt eine endliche Reihe verwendet. So kann die verwendete Funktionsentwicklung Basisfunktionen bis maximal erster oder bis maximal zweiter Ordnung umfassen.

Das Feldmodell kann an die wenigstens eine, insbesondere bereinigte, Messinformation gefittet werden. Hierbei können die den Basisfunktionen des Feldmodells zugeordneten Koeffizienten als Fitparameter, die die wenigstens eine Störinformation darstellen, verwendet werden. So lässt sich der entsprechende Lösungsansatz mithin als eine Summe von Basisfunktionen, von denen jede einen Faktor beziehungsweise Koeffizienten aufweist, der ein skalarer Wert und zunächst unbekannt ist. Diese Koeffizienten stellen hierbei die zu bestimmenden Fitparameter bei der im Rahmen dieser Ausführungsform durchgeführten Regressionsanalyse dar. Das bedeutet, dass im Rahmen des Fits eine Ausgleichsrechnung durchgeführt wird, bei der die Modellfunktion bezüglich der Werte für die Koeffizienten an die wenigstens eine Messinformation angenähert wird. Diese Annäherung kann mittels einer Chi-Quadrat-Minimierung durchgeführt werden. Die erhaltenen Ergebnisse für die Koeffizienten stellen sodann die Störinformationen dar.

In einem einfachen Fall, insbesondere alternativ zu dem Vorgehen basierend auf der Durchführung eines Fits, ist denkbar, dass mittels des Feldmodells und der wenigstens einen, insbesondere bereinigten, Messinformation ein lineares Gleichungssystem aufgestellt und gelöst wird, wobei die den Basisfunktionen des Feldmodells zugeordneten Koeffizienten die Unbekannten des Gleichungssystems sind, die die wenigstens eine Störinformation darstellen. So führt der genannte Ansatz der Funktionsentwicklung bei hinreichend vielen Werten für die Messinformation zu einem eindeutig lösbaren, linearen Gleichungssystem, dessen Lösung die wenigstens eine Störinformation liefert.

Bezüglich des wenigstens einen Feldmodells ist denkbar, dass das wenigstens ein Feldmodell mehrere separate, insbesondere orthogonale, Teilmodelle umfasst, wobei insbesondere vorgesehen ist, dass zum Ermitteln der wenigstens einen Störinformation nur ein eine Hauptfeldrichtung der Magnetresonanzeinrichtung betreffendes Teilmodell verwendet wird. Dieses Vorgehen basiert darauf, dass die Anteile des Störfeldes betreffend beide senkrecht auf der Hauptfeldrichtung beziehungsweise der z-Richtung stehende Raumrichtungen keine relevanten respektive signifikanten Störungen bezüglich des Einrichtungsmagnetfeldes verursachen und somit vernachlässigt werden können. Hierdurch verringert sich die Zahl der zu bestimmenden Parameter respektive Störinformationen, wodurch der erforderliche Rechenaufwand verringert wird.

Insbesondere wenn es sich bei dem das wenigstens eine Störfeld verursachenden Störobjekt um ein Objekt handelt, das sich nicht nur einmal, sondern häufig im Bereich der Magnetresonanzeinrichtung befindet respektive bewegt, kann die Erfassung wenigstens einer diesbezüglichen Vergleichsinformation zweckmäßig sein. Ein solches Objekt kann etwa ein Aufzug der medizinischen Einrichtung, in der sich die Magnetresonanzeinrichtung befindet, oder ein öffentliches Verkehrsmittel, beispielsweise eine Straßen- oder eine U-Bahn sein, die regelmäßig im Umfeld der Magnetresonanzeinrichtung verkehrt. Demnach kann die wenigstens eine Vergleichsinformation betreffend eine zeitliche Entwicklung der wenigstens einen Messinformation während des Auftretens eines Vergleichsstörfeldes gespeichert werden, wobei bei dem späteren Auftreten eines weiteren Störfeldes, dessen zeitliche Entwicklung dem Vergleichsstörfeld entspricht, die wenigstens eine Vergleichsinformation im Rahmen des Schritts (iii) zur Durchführung eines Plausibilitätsabgleichs verwendet wird. Konkret kann in einer Situation, während sich die Magnetfeldeinrichtung in einem Standby-Modus befindet, in dem diese kein Gradientenfeld erzeugt, die Vergleichsinformation ermittelt werden. Die Vergleichsinformation kann grundsätzlich die Messinformation selbst oder eine hieraus abgeleitete Größe sein, wobei in dem soeben genannten Fall das Störfeld nur aus dem Hauptmagnetfeld sowie dem Störfeld respektive dem Vergleichsstörfeld resultiert. Analog zu der bereinigten Messinformation kann sodann eine bereinigte Vergleichsinformation, etwa mittels einer Subtraktion, bestimmt werden. Die Erfassung der wenigstens einen Vergleichsinformation kann einmalig, bevorzugt jedoch auch während der gesamten Lebensdauer der Magnetresonanzeinrichtung erfolgen, insbesondere vor oder während der Durchführung von Bildgebungsvorgängen.

Der Plausibilitätsabgleich kann dadurch erfolgen, dass die, insbesondere bereinigte, Messinformation mit der, insbesondere bereinigten, Vergleichsinformation verglichen wird. Konkret kann eine zeitliche Entwicklung der Messinformationen mit der zeitlichen Entwicklung der Vergleichsinformationen verglichen werden und anhand dieses Vergleichs darauf geschlossen werden, ob es sich bei dem aktuellen Vorgang um einen sich wiederholenden Vorgang handelt, der im bereits der Erfassung der Vergleichsinformationen vorgelegen hat. Sofern diesbezüglich eine Übereinstimmung festgestellt wird, kann davon ausgegangen werden, dass der der Entstehung des Störfeldes zugrundeliegende Vorgang derselbe ist wie der bei der Erfassung der Vergleichsinformation. Etwaige Messfehler betreffend die Messinformation können sodann korrigiert werden. Konkret können starke Abweichungen respektive singuläre Ausreißer einzelne Messinformationen mittels der Vergleichsinformationen entsprechend korrigiert werden.

Denkbar ist, dass in Schritt (iv) das Kompensieren oder Reduzieren des wenigstens einen Störfeldes in dem Aufnahmebereich dadurch erfolgt, dass ein mittels wenigstens einer oder der wenigstens einen Gradientenspule der Magneteinrichtung generierter Anteil des in dem Aufnahmebereich vorhandenen Magnetfeldes mit einer, insbesondere zeitabhängigen, Magnetfeldänderung beaufschlagt wird, die anhand der wenigstens einen Störinformation vorgegeben wird. Gemäß dieser Ausführungsform wird das mittels der Gradientenspule zu erzeugende Gradientenfeld gezielt um eine bestimmte Abweichung geändert, wobei diese Abweichung dazu führt, dass das tatsächlich erzeugte Gradientenfeld zusammen mit dem Störfeld das eigentlich zu erzeugende Gradientenfeld ergeben und mithin das Störfeld kompensiert oder abgeschwächt wird.

Ferner ist denkbar, dass die wenigstens eine Gradientenspule aus zwei Feldspulen umfasst, insbesondere dass sich die wenigstens eine Gradientenspule aus zwei Feldspulen zusammensetzt, wobei die Feldspulen jeweils mittels einer separaten Stromquelle, die insbesondere ein Leistungsverstärker ist, zur Erzeugung des oder eines Gradientenfeldes derart bestromt werden, dass die Feldspulen in einem Maxwell-Modus betrieben werden, wobei die im Rahmen des Maxwell-Moduls erfolgende Bestromung der Feldspulen gegensinnig ausgeprägt ist und die Erzeugung des Gradientenfeldes bewirkt. Bei dem Maxwell-Modus, der auch als Anti-Helmholtz-Modus bezeichnet wird, ergibt sich zwischen den Feldspulen ein Magnetfeld, das einen zumindest näherungsweise konstanten Feldgradienten aufweist, sodass sich die Feldstärke des Gradientenfeldes zumindest näherungsweise linear ändert.

Bevorzugt ist vorgesehen, dass der im Rahmen des Maxwell-Modus erfolgenden Bestromung ein Gradientenoffset aufgeprägt wird, mittels dem ein linearer Anteil des Störfeldes kompensiert oder reduziert wird. Bezüglich der bereits oben genannten Funktionsentwicklung wird hierbei der Koeffizient betreffend die Basisfunktion erster Ordnung verwendet, insbesondere betreffend die z-Richtung. Zudem kann mittels des Gradientenoffsets eine Abweichung des Hauptmagnetfeldes von einem idealen, homogenen Magnetfeld reduziert oder kompensiert werden.

Zudem oder alternativ können die Feldspulen zusätzlich in einem Helmholtz-Modus betrieben werden, wobei die im Rahmen des Helmholtz-Modus erfolgende Bestromung der Feldspulen gleichsinnig ausgeprägt ist und das Kompensieren oder Reduzieren eines konstanten Anteils des Störfeldes bewirkt. Bezüglich des bereits oben genannten Ansatzes betreffend die Funktionsentwicklung wird hierbei der Koeffizient betreffend die Basisfunktion nullter Ordnung verwendet, insbesondere betreffend die z-Richtung. Mittels der in dem Helmholtz-Modus erfolgenden Bestromung der Feldspulen wird eine Abweichung des Einrichtungsmagnetfeldes bezüglich einer konstanten Verschiebung der Magnetfeldstärke, die aufgrund des Störfeldes vorliegt, reduziert oder kompensiert. Besonders bevorzugt erfolgt Bestromung der Feldspulen in einem Mischmodus, der sowohl einen Anteil gemäß dem Maxwell-Modus und einen Anteil gemäß dem Helmholtz-Modus umfasst, die sich additiv zusammensetzen.

Ferner betrifft die vorliegende Erfindung eine Magnetresonanzeinrichtung zur Durchführung des Verfahrens gemäß der vorangehenden Beschreibung, wobei mittels der Magnetresonanzeinrichtung eine Bildgebung zur Erfassung von Bilddaten durchführbar ist, die ein Objekt betreffen, das in einem Aufnahmebereich der Magnetresonanzeinrichtung angeordnet ist, wobei die Magnetresonanzeinrichtung eine Magneteinrichtung umfasst, mittels der ein in dem Aufnahmebereich vorliegendes Einrichtungsmagnetfeld erzeugbar ist, wobei ein tatsächlich in dem Aufnahmebereich vorhandenes, gestörtes Magnetfeld aus dem Einrichtungsmagnetfeld und wenigstens einem Störfeld resultiert, wobei das Störfeld von einem sich außerhalb des Aufnahmebereichs befindenden Störobjekts verursacht wird, wobei mittels wenigstens eines Magnetsensors wenigstens eine Messinformation erfassbar ist, die ein außerhalb des Aufnahmebereichs vorliegendes und aus dem Einrichtungsmagnetfeld und dem wenigstens einen Störfeld resultierendes Streumagnetfeld betrifft, wobei mittels einer Steuerungseinrichtung wenigstens einer Störinformation betreffend das wenigstens eine Störfeld unter Verwendung der wenigstens einen Messinformation ermittelbar ist, wobei die Steuerungseinrichtung dazu eingerichtet ist, Steuersignale derart zu generieren und an die Magnetresonanzeinrichtung auszugeben, dass das wenigstens eine Störfeld in dem Aufnahmebereich mittels einer Änderung des Einrichtungsmagnetfeldes unter Verwendung der wenigstens einen Störinformation kompensierbar oder reduzierbar ist. Gelöst wird die Aufgabe der Erfindung bei dieser Magnetresonanzeinrichtung erfindungsgemäß dadurch, dass die Steuerungseinrichtung dazu eingerichtet ist, zum Ermitteln der wenigstens einen Störinformation eine mathematische Modellierung des wenigstens einen Störfeldes unter Verwendung der wenigstens einen Messinformation durchzuführen, wobei zur Modellierung wenigstens ein ein Vektorfeld beschreibendes Feldmodell für das wenigstens eine Störfeld verwendet wird. Der wenigstens eine Magnetsensor kann eine Komponente der Magnetresonanzeinrichtung sein. Alternativ ist der wenigstens eine Magnetsensor eine bezüglich der Magnetresonanzeinrichtung separate Komponente. Alle im Zusammenhang mit dem erfindungsgemäßen Verfahren erläuterten Merkmale, Vorteile und Aspekte sind gleichermaßen auf die erfindungsgemäße Magnetresonanzeinrichtung übertragbar und umgekehrt.

Die Steuerungseinrichtung der erfindungsgemäßen Magnetresonanzeinrichtung ist somit zur Durchführung der im Zusammenhang mit dem oben erläuterten, erfindungsgemäßen Verfahren vorgesehenen Schritte ausgebildet und eingerichtet. Dies gilt insbesondere für die Ermittlung der im Zuge der Durchführung dieses Verfahrens vorgesehenen Informationen anhand der Signale des wenigstens einen Magnetsensors. Dies gilt ferner bevorzugt für die Auswertung respektive Verarbeitung dieser Signale und/oder Informationen sowie für die Generierung der im Zuge der Generierung des Einrichtungsmagnetfeldes vorgesehenen Steuersignale.

Weiterhin betrifft die vorliegende Erfindung eine Steuerungseinrichtung für eine Magnetresonanzeinrichtung gemäß der vorangehenden Beschreibungspassagen, umfassend eine Speichereinheit, auf der ein ausführbares Computerprogramm gespeichert ist, das dazu geeignet ist, durch eine Verarbeitungseinrichtung der Steuerungseinrichtung gelesen zu werden und hierbei die Verarbeitungseinrichtung dazu zu veranlassen, die wenigstens eine Störinformation betreffend das wenigstens eine Störfeld unter Verwendung der wenigstens einen Messinformation zu ermitteln und die Steuersignale derart zu generieren und an die Magnetresonanzeinrichtung auszugeben, dass das wenigstens eine Störfeld in dem Aufnahmebereich mittels einer Änderung des Einrichtungsmagnetfeldes unter Verwendung der wenigstens einen Störinformation kompensiert oder reduziert wird. Alle im Zusammenhang mit dem erfindungsgemäßen Verfahren und der erfindungsgemäßen Magnetresonanzeinrichtung erläuterten Merkmale, Vorteile und Aspekte sind gleichermaßen auf die erfindungsgemäße Steuerungseinrichtung übertragbar und umgekehrt.

Schließlich betrifft die vorliegende Erfindung eine Speichereinheit für eine Steuerungseinrichtung gemäß der vorangehenden Beschreibungspassage, wobei auf der Speichereinheit ein ausführbares Computerprogramm gespeichert ist, das dazu geeignet ist, durch eine Verarbeitungseinrichtung der Steuerungseinrichtung gelesen zu werden und hierbei die Verarbeitungseinrichtung dazu zu veranlassen, die wenigstens eine Störinformation betreffend das wenigstens eine Störfeld unter Verwendung der wenigstens einen Messinformation zu ermitteln und die Steuersignale derart zu generieren und an die Magnetresonanzeinrichtung auszugeben, dass das wenigstens eine Störfeld in dem Aufnahmebereich mittels einer Änderung des Einrichtungsmagnetfeldes unter Verwendung der wenigstens einen Störinformation kompensiert oder reduziert wird. Alle im Zusammenhang mit dem erfindungsgemäßen Verfahren, der erfindungsgemäßen Magnetresonanzeinrichtung und der erfindungsgemäßen Steuerungseinrichtung erläuterten Merkmale, Vorteile und Aspekte sind gleichermaßen auf die erfindungsgemäße Speichereinheit übertragbar und umgekehrt.

Weitere Vorteile, Merkmale und Aspekte der vorliegenden Erfindung ergeben sich aus den nachfolgend dargelegten Ausführungsbeispielen sowie anhand der Figuren. Diese zeigen schematisch:

Fig. 1      ein Flussdiagramm eines erfindungsgemäßen Verfahrens gemäß einem Ausführungsbeispiel,

Fig. 2      eine Prinzipskizze einer erfindungsgemäßen Magnetresonanzeinrichtung gemäß einem Ausführungsbeispiel, umfassend eine erfindungsgemäße Steuerungseinrichtung gemäß einem Ausführungsbeispiel mit einer erfindungsgemäßen Speichereinheit gemäß einem Ausführungsbeispiel,

Fig. 3      eine perspektivische Darstellung eines Raumes, in dem sich die Magnetresonanzeinrichtung der Fig. 2 befindet,

Fig. 4      eine weitere perspektivische Darstellung des Raumes der Fig. 3, und

Fig. 5, 6    schematische Darstellungen einer Gradientenspulenanordnung der Magnetresonanzeinrichtung der Fig. 2 betreffend verschiedene Betriebsmodi.

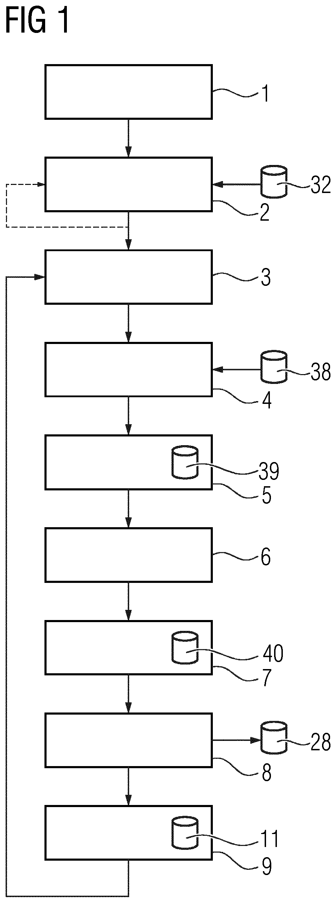

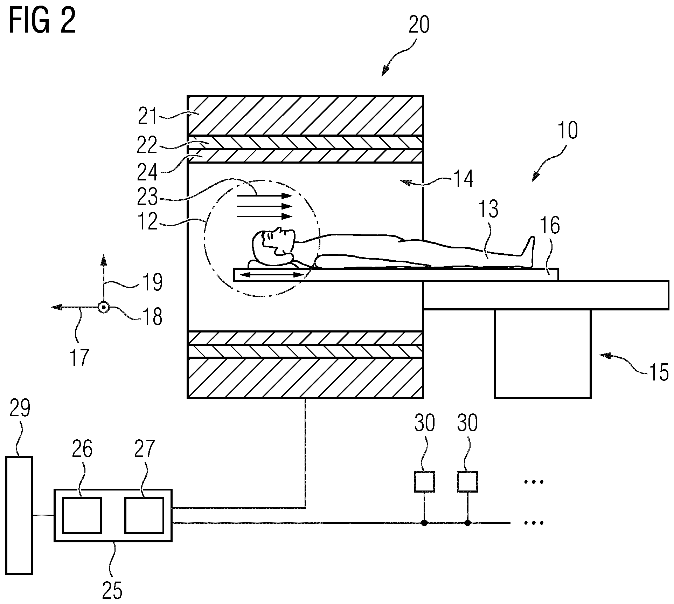

Fig. 1 zeigt ein Flussdiagramm eines erfindungsgemäßen, computerimplementierten Verfahrens gemäß einem Ausführungsbeispiel. Vorliegend umfasst das Verfahren die Schritte 1 - 9 und ist auf den Betrieb einer erfindungsgemäßen Magnetresonanzeinrichtung 10 gemäß einem Ausführungsbeispiel gerichtet. Fig. 2 zeigt einen schematischen Längsschnitt durch die Magnetresonanzeinrichtung 10. Im Zuge der Durchführung des anhand der Fig. 1 erläuterten Verfahrens werden Bilddaten 11 erfasst, die ein in einem Aufnahmebereich 12 der Magnetresonanzeinrichtung 10 angeordnetes Objekt 13 respektive einen Patienten betreffen.

Unter Bezugnahme auf die Fig. 2 umfasst die Magnetresonanzeinrichtung 10 einen röhrenförmigen Patientenaufnahmebereich 14 respektive Patiententunnel, der den kugelförmig geformten Aufnahmebereich 12, der auch als "Field of View" bezeichnet wird, umfasst. Das Objekt 13 kann mittels einer Patientenlagerungsvorrichtung 15 in den Patientenaufnahmebereich 14 eingeschoben werden. Die Patientenlagerungsvorrichtung 15 weist hierzu einen in den Patientenaufnahmebereich 14 hineinbewegbaren Patiententisch 16 auf.

Nachfolgend werden relevante, kartesische Raumrichtungen 17, 18, 19 bezüglich der Magnetresonanzeinrichtung 10 eingeführt. Eine horizontal verlaufende Raumrichtung 17, die auch als Hauptfeld- oder z-Richtung bezeichnet wird, erstreckt sich entlang einer Längsrichtung des zylindrischen Patientenaufnahmebereichs 14. Eine zweite, horizontal verlaufende Raumrichtung 18, die auch als x-Richtung bezeichnet wird, erstreckt sich senkrecht zur Raumrichtung 17. Weiterhin ist eine vertikal verlaufende Raumrichtung 19 vorgesehen, die senkrecht auf den anderen beiden Raumrichtungen 17, 18 steht und auch als y-Richtung bezeichnet wird.

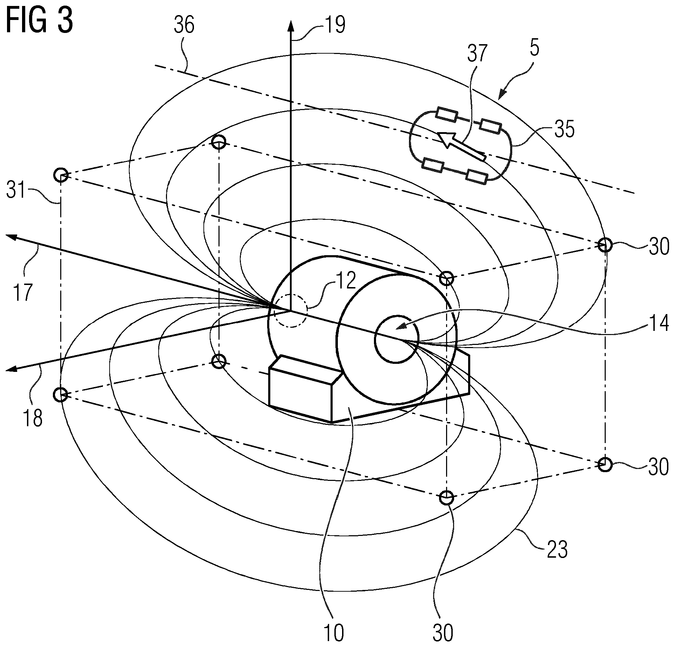

Weiterhin umfasst die Magnetresonanzeinrichtung 10 eine Magneteinrichtung 20, die eine Hauptfeldspule 21 sowie drei Gradientenspulenanordnungen 22 umfasst, die in Fig. 2 nur äußerst schematisch angedeutet sind. Mittels der Hauptfeldspule 21 ist in dem Aufnahmebereich 12 ein näherungsweise homogenes Hauptmagnetfeld erzeugbar, dessen Feldlinien entlang der Hauptfeldrichtung und mithin Raumrichtung 17 ausgerichtet sind. Mittels der Gradientenspulenanordnungen 22 sind drei Gradientenfelder erzeugbar, mittels denen Feldgradienten betreffend die Raumrichtungen 17, 18, 19 erzeugt werden. Das Hauptmagnetfeld sowie die Gradientenfelder bilden insgesamt ein Einrichtungsmagnetfeld 23. Die Feldlinien des Einrichtungsmagnetfeldes 23 sind in den Figuren 2 und 3 schematisch angedeutet, wobei Fig. 3 eine perspektivische Darstellung eines Raumes 31 zeigt, in dem sich die Magnetresonanzeinrichtung 10 befindet. Weiterhin umfasst die Magneteinrichtung 20 eine Hochfrequenzantenneneinheit 24, mittels der hochfrequente Magnetresonanzsequenzen in den Aufnahmebereich 12 eingestrahlt werden und die überdies zum Empfangen der hieraus resultierenden Magnetresonanzsignale ausgebildet ist, wobei die Magnetresonanzsignale die Bilddaten 11 sind beziehungsweise zur Bestimmung der Bilddaten 11 verwendet werden.

Ferner umfasst die Magnetresonanzeinrichtung 10 eine erfindungsgemäße Steuerungseinrichtung 25 gemäß einem Ausführungsbeispiel, die wiederum eine erfindungsgemäße Speichereinheit 26 gemäß einem Ausführungsbeispiel umfasst. Die Steuerungseinrichtung 25 umfasst eine Verarbeitungseinrichtung 27, mittels der ein auf der Speichereinheit 26 gespeichertes Computerprogramm ausführbar ist, wobei dieses Ausführen gemäß dem nachfolgend Beschriebenen die Generierung von Steuersignalen 28 bewirkt, mittels denen der Betrieb der Magneteinrichtung 20 gesteuert wird. Zudem ist die Steuerungseinrichtung 25 mit einer Benutzerschnittstelle 29 der Magnetresonanzeinrichtung 10 verbunden. Mittels einer Eingabeeinheit der Benutzerschnittstelle 29 sind nutzerseitige Steuerinformationen wie beispielsweise Bildgebungsparameter seitens eines medizinischen Bedienungspersonals vorgebbar. Weiterhin können mittels einer Anzeigeeinheit der Benutzerschnittstelle 29 rekonstruierte Magnetresonanzabbildungen angezeigt werden.

Nachfolgend werden anhand des Flussdiagramms der Fig. 1 die Schritte des Verfahrens erläutert. Im ersten Schritt 1 erfolgt, insbesondere einmalig bei Inbetriebnahme der Magnetresonanzeinrichtung 10, eine Kalibration von Magnetsensoren 30 der Magnetresonanzeinrichtung 10. Die acht Magnetsensoren 30 sind an einer Wand respektive einer Decke respektive einem Fußboden des Raumes 31 angeordnet. Die Magnetsensoren 30 sind außerhalb des Aufnahmebereichs 12 respektive der Magnetresonanzeinrichtung 10 angeordnet, und zwar in den acht Ecken des Raumes 31, sodass die Magnetsensoren 30 quaderförmig zueinander angeordnet sind. Zur Kalibration werden mittels der Gradientenspulenanordnungen 22 Kalibriersignale generiert und ausgegeben, etwa sogenannte Chirp- oder Dreieckspulse, wobei die anhand der Kalibriersignale erfassten Messwerte der Magnetsensoren 30 aufgrund der Kenntnis der Parameter der Kalibriersignale und der Kenntnis der Relativpositionen und gegebenenfalls Neigungen der Magnetsensoren 30 bezüglich des Referenzsystems respektive des Isozentrums der Magnetresonanzeinrichtung 10 zur Kalibrierung der Magnetsensoren 30 genutzt werden können.

Für den zweiten Schritt 2 wird davon ausgegangen, dass sich die Magnetresonanzeinrichtung 10 in einem Standby-Modus befindet, in dem mittels der Hauptfeldspule 21 das Hauptmagnetfeld generiert wird und die Gradientenspulenanordnungen 22 kein Gradientenfeld erzeugen, sodass das Einrichtungsmagnetfeld 23 ausschließlich aus dem Hauptmagnetfeld resultiert. In Schritt 2 erfolgt die Erfassung von Vergleichsinformationen 32 während des Auftretens eines Störfeldes 33, das im Zusammenhang mit der Erfassung der Vergleichsinformationen 32 als ein Vergleichsstörfeld 34 bezeichnet wird. Das Einrichtungsmagnetfeld 23 sowie das Störfeld 33 bewirken ein außerhalb der Magnetresonanzeinrichtung 10 vorliegendes Streumagnetfeld. Das Einrichtungsmagnetfeld 23 respektive der aus dem Einrichtungsmagnetfeld 23 resultierende Teil des Streumagnetfeldes kann als bekannt vorausgesetzt und als

$$\vec{B}_{0,G}(\vec{r},t) = \vec{B}_0(\vec{r}) + \vec{B}_G(\vec{r},t)$$

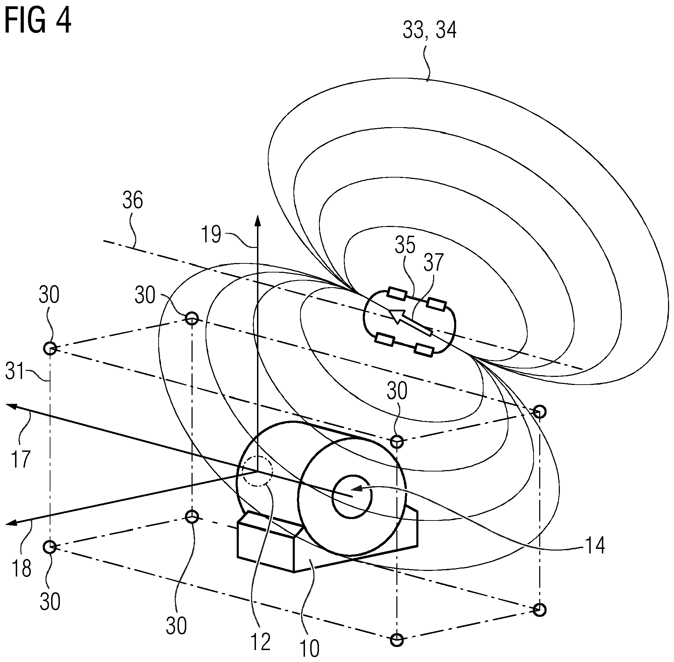

geschrieben werden, wobei der erste Term dieser Summe den Anteil des Einrichtungsmagnetfeldes 23 aus dem Hauptmagnetfeld und der zweite Term den Anteil des Einrichtungsmagnetfeldes 23 aus den Gradientenfeldern bezeichnet. Die mit einem Vektorpfeil gekennzeichneten Größen sind dreidimensionale Vektoren, wobei der zweite Term zusätzlich zeitabhängig ist. Zur Veranschaulichung des Störfeldes 33 beziehungsweise des Vergleichsstörfeldes 34 wird auf die Fig. 4 verwiesen, die grundsätzlich der Fig. 3 entspricht, jedoch anstelle der Feldlinien des Einrichtungsmagnetfeldes 23 die Feldlinien des Störfeldes 33 beziehungsweise des Vergleichsstörfeldes 34 zeigt.

Das Störfeld 33 beziehungsweise das Vergleichsstörfeld 34 wird von einer sich in der Nähe der Magnetresonanzeinrichtung 10 respektive des Raumes 31 bewegenden, ferromagnetischen Quelle verursacht, wobei die Quelle nachfolgend als Störobjekt 35 bezeichnet wird und vorliegend beispielhaft ein sich entlang einer Trajektorie 36 bewegendes Kraftfahrzeug ist. Bei dem Störobjekt 35 kann es sich gleichermaßen um einen Aufzug oder ein öffentliches Verkehrsmittel wie eine Straßen- oder eine U-Bahn handeln. Aufgrund der ferromagnetischen Eigenschaften des Störobjekts 35 induziert das Einrichtungsmagnetfeld 23 ein magnetisches Moment 37 in dem Störobjekt 35, das wiederum die Entstehung des Störfeldes 33 beziehungsweise des Vergleichsstörfeldes 34 bewirkt. Gemäß der Superpositionstheorie setzt sich das mittels der Magnetsensoren 30 messtechnisch erfassbare Streumagnetfeld additiv aus dem aus dem Einrichtungsmagnetfeld 23 und aus dem Störfeld 33 zusammen, sodass

$$\vec{B}_{0,G,D}(\vec{r},t) = \vec{B}_{0,G}(\vec{r},t) + \vec{B}_D(\vec{r},t)$$

gilt, wobei der Ausdruck auf der linken Seite das Streumagnetfeld und, bezogen auf die rechte Seite dieser Gleichung, der erste Term dieser Summe das Einrichtungsmagnetfeld 23 und der zweite Term das Störfeld 33 beziehungsweise das Vergleichsstörfeld 34 bezeichnet. Aufgrund dessen, dass sich die Magnetresonanzeinrichtung 10 in dem Standby-Modus befindet, in der keine Gradientenfelder vorliegen, gilt für das Streumagnetfeld

$$\vec{B}_{0,G,D}(\vec{r},t) = \vec{B}_0(\vec{r}) + \vec{B}_G(\vec{r},t) + \vec{B}_D(\vec{r},t) = \vec{B}_0(\vec{r}) + \vec{B}_D(\vec{r},t)$$

Mittels der Magnetsensoren 30 werden nun Messwerte betreffend das Streumagnetfeld ermittelt, die an die Steuerungseinrichtung 25 ausgegeben werden und seitens der Verarbeitungseinrichtung 27 verarbeitet werden. Mittels der Magnetsensoren 30 wird hierzu ein Magnetvektor, also drei Zahlenwerte, erfasst, wobei jeder der Zahlenwerte einen Betrag des gemessenen Streumagnetfeldes entlang einer der drei Raumrichtungen 17, 18, 19 angibt. Die das Vergleichsstörfeld 34 betreffend Vergleichsinformation 32 wird sodann dadurch ermittelt, dass von jedem dieser Zahlenwerte der bekannte und anhand des Einrichtungsmagnetfeldes 23 vorliegende Teil des gemessenen Streumagnetfeldes, der als eine bekannte Einrichtungsinformation vorliegt, abgezogen wird. Folglich wird

$$\vec{B}_D(\vec{r},t) = \vec{B}_{0,G,D}(\vec{r},t) - \vec{B}_0(\vec{r})$$

berechnet und als die Vergleichsinformation 32, die aufgrund dieser Subtraktion als eine bereinigte Vergleichsinformation bezeichnet werden kann, abgespeichert. Dieser Vorgang wird nun während des Auftretens des Vergleichsstörfeldes 34 mehrmals nacheinander und zu verschiedenen Zeitpunkten durchlaufen, sodass anhand der so ermittelten Vergleichsinformationen 32 eine zeitliche Entwicklung der Werte der Vergleichsinformation 32 bezüglich des Auftretens des Vergleichsstörfeldes 34 vorliegt. Dies wird in Fig. 1 anhand des gestrichelten Pfeils angedeutet. Hierbei wird ein Satz an Vergleichsinformationen 32 erhoben, der, wie nachfolgend noch im Detail erläutert wird, zur Überprüfung einer Plausibilität bei erneutem Auftreten dieser beziehungsweise einer zumindest ähnlichen Störung genutzt werden kann.

Es wird darauf hingewiesen, dass die im Rahmen des Schritts 2 vorgesehene Erfassung der Vergleichsinformationen 32 nicht nur einmalig bei der Inbetriebnahme der Magnetresonanzeinrichtung 10 durchgeführt werden kann, sondern auch während deren Lebensdauer, insbesondere im Zuge der Durchführung der Erfassung der Bilddaten 11, etwa bevor die eigentliche Bilderfassung stattfindet und sich die Magnetresonanzeinrichtung noch in dem Standby-Modus befindet. Es werden mithin mehrere Sätze an Vergleichsinformationen 32 erhoben und abgespeichert, die jeweils einem spezifischen Vorgang zur Entstehung des Störfeldes 33 zugeordnet sind.

Im dritten Schritt 3 erzeugen die Gradientenspulenanordnungen 22 die Gradientenfelder, wobei die resultierenden Feldgradienten eine Zuordnung der hiernach erfassten Bilddaten 11 zu entsprechenden Positionen innerhalb des Aufnahmebereichs 12 ermöglichen.

Im vierten Schritt 4 werden mittels der Magnetsensoren 30 Messinformationen 38 betreffend das aktuell vorliegende Streumagnetfeld ermittelt. Die Messinformationen 38 sind gemäß dem im bereits Zusammenhang mit der Ermittlung der Vergleichsinformationen 32 Erläuterten jeweils ein entsprechender Magnetvektor umfassend drei skalare Werte.

Im fünften Schritt 5 werden anhand der erfassten Messinformationen 38 bereinigte Messinformationen 39 ermittelt, und zwar anhand einer Subtraktion gemäß

$$\vec{B}_D(\vec{r},t) = \vec{B}_{0,G,D}(\vec{r},t) - \vec{B}_{0,G}(\vec{r},t)$$

Die resultierende, bereinigte Messinformation 39 betrifft mithin nunmehr ausschließlich das Störfeld 33, wobei der erste Term auf der rechten Seite dieser Gleichung anhand der Messinformation 38 vorliegt und das gemessene Streumagnetfeld betrifft, wobei der zweite Term das Einrichtungsmagnetfeld 23 betrifft. Hierbei sind die Werte für das Einrichtungsmagnetfeld 23 betreffend die Positionen der Magnetsensoren 30 anhand der Parameter, mittels denen die Magneteinrichtung 20 betrieben wird, als die bereits genannte Einrichtungsinformation bekannt. Auch diesem Vorgehen liegt die Superpositionstheorie zugrunde, gemäß der sich das Streumagnetfeld additiv aus dem Einrichtungsmagnetfeld 23 und dem Störfeld 33 zusammensetzt.

Im nächsten, optionalen Schritt 6 des Verfahrens erfolgt unter Verwendung der bereinigten Vergleichsinformationen 32 ein Plausibilitätsabgleich betreffend die bereinigten Messinformationen 39. Hierzu wird davon ausgegangen, dass die Schritte 3 - 9 bereits mehrfach nacheinander durchlaufen wurden, sodass bezüglich der bereinigten Messinformationen 39 eine zeitliche Entwicklung vorliegt. Mithin wird der Schritt 6 beim erstmaligen Durchlaufen dieser Schritte noch nicht durchgeführt. So wird der zeitliche Verlauf betreffend die bereinigten Messinformationen 39 mit dem zeitlichen Verlauf betreffend die bereinigten Vergleichsinformationen 32 abgeglichen. Falls dieser Abgleich ergibt, dass diese zeitlichen Verläufe einander entsprechen, dann ist davon auszugehen, dass es sich bei dem Vorgang, der zum Vorliegen des Vergleichsstörfeldes 34 geführt hat, um den selben Vorgang handelt, der aktuell zum Vorliegen des Störfeldes 33 führt. Beispielsweise kann es sich hierbei um einen Vorgang handeln, bei dem das das Störfeld 33 bewirkende Störobjekt 35 ein an dem Raum 31 entlangbewegender Aufzug oder eine Straßen- oder U-Bahn ist. In diesem Fall werden starke Abweichungen bei einzelnen, bereinigten Messinformationen 39 mittels der Vergleichsinformationen 32 entsprechend korrigiert.

Im siebten Schritt 7 werden anhand der bereinigten Messinformationen 39 Störinformationen 40 betreffend das aktuell vorliegende Störfeld 33 ermittelt. Hierzu erfolgt eine mathematische Modellierung des Störfeldes 33 unter der Voraussetzung beziehungsweise dem Ansatz, dass es sich bei dem Störfeld 33 um ein harmonisches Feld handelt, das ein, betreffend zumindest den Aufnahmebereich 12, quellenfreies Feld ist. So lässt sich das Störfeld 33 mittels eines Vektorfeldes beschreiben, das die Laplace-Gleichung

$$\Delta \vec{B}_D(\vec{r},t) = (\boldsymbol{\nabla} \cdot \boldsymbol{\nabla})\, \vec{B}_D(\vec{r},t) = 0$$

erfüllt, wobei $\Delta$ den Laplace-Operator bezeichnet. Zur Bestimmung der Störinformationen 40 erfolgt nun ein Ansatz derart, dass das verwendete Feldmodell auf einer Funktionsentwicklung beruht, sodass bezüglich der drei Raumrichtungen 17, 18, 19 die Zusammenhänge

$$B_{D,x} = \sum_{h=1}^{H} C_{x,h} \cdot SH_h(\vec{r})$$

$$B_{D,y} = \sum_{h=1}^{H} C_{y,h} \cdot SH_h(\vec{r})$$

$$B_{D,z} = \sum_{h=1}^{H} C_{z,h} \cdot SH_h(\vec{r})$$

gelten. Hierbei bezeichnen $C_{x,h}$, $C_{y,h}$, und $C_{z,h}$ die den räumlich harmonischen Basisfunktionen $SH_h$ zugeordneten Koeffizienten, wobei diese auf den dreidimensionalen, kartesischen Raum definierten Basisfunktionen $SH_h$ häufig auch als "spatial harmonics" bezeichnet werden. Ersichtlich umfasst das verwendete Feldmodell drei separate, orthogonale Teilmodelle, die durch die vorgenannten Gleichungen vorgegeben sind.

Bezüglich dieses Ansatzes können Basisfunktionen bis maximal erster Ordnung verwendet werden respektive Berücksichtigung finden, sodass H = 4 gilt. In diesem Fall sind grundsätzlich die Messwerte der acht Magnetsensoren 30 ausreichend, um die unbekannten Koeffizienten zu bestimmen. Denkbar ist auch, dass Basisfunktionen bis maximal zweiter Ordnung verwendet werden respektive Berücksichtigung finden, sodass H = 9 gilt. In diesem Fall wären die Messwerte von neun Magnetsensoren 30 erforderlich, um die unbekannten Koeffizienten $C_{x,n}$, $C_{y,h}$, und $C_{z,h}$ zu bestimmen. Auch kann zur Reduzierung der Anzahl der zur Bestimmung der unbekannten

Koeffizienten erforderlichen Magnetsensoren 30 lediglich die dritte der vorgenannten Gleichungen verwendet werden, sodass bezüglich der Ermittlung der Störinformationen 40 lediglich eine Auswertung der Hauptfeld- respektive z-Richtung, also bezüglich der Raumrichtung 17, erfolgt und nur die Koeffizienten $C_{z,h}$ bestimmt werden.

Ergänzend werden nachfolgend die konkreten, kartesischen Ausdrücke für die Basisfunktionen $SH_h$ angegeben. So gilt für die nullte Ordnung, dass SH, (x,y,z) = 1 ist. Zudem gilt für die erste Ordnung, dass $SH_2$ (x,y,z) = x, $SH_3$ (x,y,z) = y und $SH_4$ (x,y,z) = z ist. Ferner gilt für die zweite Ordnung, dass $SH_5$ (x,y,z) = xy, $SH_6$ (x,y,z) = zy, $SH_7$ (x,y,z) = $2z^2$ - $x^2$ - $y^2$, $SH_8$ (x,y,z) = xz und $SH_9$ (x,y,z) = $x^2$ - $y^2$ ist.

Zur Bestimmung der Koeffizienten $C_{x,n}$, $C_{y,h}$, und $C_{z,h}$ erfolgt mittels der Steuerungseinrichtung 25 ein Fit, also eine Regressionsanalyse, unter Verwendung der Funktionsentwicklung sowie der bereinigten Messinformationen 39. Zudem ist denkbar, sofern die Anzahl der verwendeten Magnetsensoren 30 hinreichend hoch ist, dass anhand des erläuterten Ansatzes ein lineares Gleichungssystem aufgestellt wird, das mittels der Steuerungseinrichtung 25 entsprechend gelöst werden kann. In jedem Fall führt die Bestimmung der Koeffizienten $C_{x,n}$, $C_{y,h}$, und $C_{z,h}$ zu einem das Störfeld 33 beschreibenden Modell.

Im achten Schritt 8 werden die Steuersignale 28 mittels der Steuerungseinrichtung 25 derart generiert und an die Magneteinrichtung 20 ausgegeben, dass das Störfeld 33 in dem Aufnahmebereich 12 kompensiert oder zumindest reduziert wird. Hierzu erfolgt eine Änderung respektive Anpassung des Einrichtungsmagnetfeldes 23 unter Verwendung der Störinformationen 40 gemäß dem nachfolgend Erläuterten. Hierzu wird beispielhaft ausschließlich auf die Hauptfeldrichtung beziehungsweise die Raumrichtung 17 Bezug genommen, wobei für die beiden Raumrichtungen 18, 19 dasselbe analog gilt. So erfolgt das Kompensieren oder zumindest Reduzieren des Störfeldes 33 in dem Aufnahmebereich 12 mittels den Gradientenspulenanordnungen 22 derart, dass der hiermit generierte Anteil des in dem Aufnahmebereich 12 vorhandenen Magnetfeldes mit einer zeitabhängigen Magnetfeldänderung beaufschlagt wird, die anhand der Störinformationen 40 vorgegeben wird.

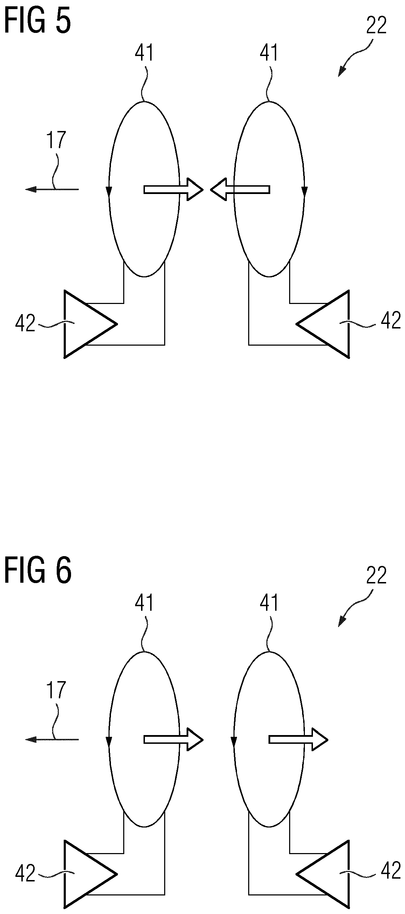

Die Figuren 5 und 6 zeigen jeweils eine schematische Ansicht einer der Gradientenspulenanordnungen 22, und zwar derjenigen, mittels der der Feldgradient betreffend die Raumrichtung 17 erzeugt wird. Für die beiden anderen Gradientenspulenanordnungen 22 gilt das nachfolgend Erläuterte analog. So setzt sich die Gradientenspulenanordnung 22 aus zwei parallel und kollinear zueinander angeordneten Feldspulen 41 zusammen. Jede der Feldspulen 41 wird mit einer separaten Stromquelle 42, die vorliegend jeweils ein Leistungsverstärker ist, anhand der Steuersignale 28 separat bestromt. Hierbei erfolgt der Betrieb der Feldspule in 41 gemäß einem Mischmodus, der eine Mischform aus einem in der Fig. 5 angedeuteten Maxwell-Modus und einem in der Fig. 6 angedeuteten Helmholtz-Modus darstellt.

Bezüglich des Maxwell-Modus erfolgt eine gegensinnige Bestromung der Feldspulen 41 zur Erzeugung des Gradientenfeldes. Der diesbezügliche Anteil des durch die Feldspulen 41 fließenden Stroms wird mit $I_{z,grad}$ bezeichnet. Diesem Anteil wird ein mit $I_{z,offset}$ bezeichneter Gradientenoffset aufgeprägt, mittels dem der lineare Anteil des Störfeldes 33 kompensiert oder zumindest reduziert wird, wobei sich der Gradientenoffset $I_{z,offset}$ aus dem ermittelten Wert für den Koeffizienten $C_{z,h=4}$ ergibt.

Bezüglich des Helmholtz-Modus erfolgt eine gleichsinnige Bestromung der Feldspulen 41, wobei mittels des entsprechenden Anteils der Bestromung das Kompensieren beziehungsweise zumindest das Reduzieren eines Anteils nullter Ordnung des Störfeldes 33, also eines konstanten Anteils, bewirkt wird. Dieser mit $I_{z,shift}$ bezeichnete Anteil wird bezüglich der Steuerinformationen 40 aus dem ermittelten Wert für den $C_{z,h=1}$ ergibt bestimmt. Insgesamt ergeben sich somit die Ströme $I_1$ und $I_2$ der beiden Feldspulen 41 zu

$$I_1 = I_{z,grad}(t) + I_{z,offset} + I_{z,shift}$$

und

$$I_2 = -I_{z,grad}(t) - I_{z,offset} + I_{z,shift}.$$

Im neunten Schritt 9 erfolgt die Erfassung der Bilddaten 11 mittels der Hochfrequenzantenneneinheit 24. Die Schritte 3 - 9 werden nun iterativ so lange wiederholt durchlaufen, bis alle erforderlichen Bilddaten 11 erfasst wurden. Die nacheinander durchlaufenen Schritte 3 - 8 bewirken, dass einer etwaigen zeitlichen Änderung des Störfeldes 33 Rechnung getragen wird.

Ergänzend wird angemerkt, dass die im Zuge der vorbeschriebenen Durchführung der Verfahrensschritte 3 - 9 erfassten Informationen 38, 39, 40, insbesondere die bereinigten Messinformationen 39, als ein weiterer Satz an Vergleichsinformationen 32 hinterlegt werden kann, der gemäß dem oben Beschriebenen bei später auftretenden Störungen zur Plausibilisierung herangezogen werden kann.

Weiterhin wird ergänzend angemerkt, dass das erfindungsgemäße Vorgehen auch dann angewendet werden kann, wenn sich mehrere Störobjekte 35 in der Umgebung der Magnetresonanzeinrichtung 10 befinden, wobei in diesem Fall entsprechend mehrere Störfelder 33 vorliegen. Aufgrund der oben genannten Quellenfreiheit der Störfelder ist es möglich, diese gemeinsam mittels der zuvor beschriebenen Modellierung abzubilden.

Unabhängig vom grammatikalischen Geschlecht eines bestimmten Begriffes sind Personen mit männlicher, weiblicher oder anderer Geschlechteridentität mit umfasst.

**Patentansprüche**

1. Verfahren zum Betrieb einer Magnetresonanzeinrichtung (10), wobei mittels der Magnetresonanzeinrichtung (10) eine Bildgebung zur Erfassung von Bilddaten (11) durchführbar ist, die ein Objekt (13) betreffen, das in einem Aufnahmebereich (12) der Magnetresonanzeinrichtung (10) angeordnet ist, wobei zur Durchführung der Bildgebung die folgenden Schritte ausgeführt werden:

   (i) Erzeugung eines in dem Aufnahmebereich (12) vorliegenden Einrichtungsmagnetfeldes (23) mittels einer Magneteinrichtung (20) der Magnetresonanzeinrichtung (10), wobei ein tatsächlich in dem Aufnahmebereich (12) vorhandenes, gestörtes Magnetfeld aus dem Einrichtungsmagnetfeld (23) und wenigstens einem Störfeld (33) resultiert, wobei das Störfeld (33) von einem sich außerhalb des Aufnahmebereichs (12) befindenden Störobjekt (35) verursacht wird,
   (ii) Erfassen wenigstens einer Messinformation (38) mittels wenigstens eines Magnetsensors (30), wobei die Messinformation (38) ein außerhalb des Aufnahmebereichs (12) vorliegendes und aus dem Einrichtungsmagnetfeld (23) und dem wenigstens einen Störfeld (33) resultierendes Streumagnetfeld betrifft,
   (iii) Ermitteln wenigstens einer Störinformation (40) betreffend das wenigstens eine Störfeld (33) unter Verwendung der wenigstens einen Messinformation (38),
   (iv) Kompensieren oder Reduzieren des wenigstens einen Störfeldes (33) in dem Aufnahmebereich (12) mittels einer Änderung des Einrichtungsmagnetfeldes (23) unter Verwendung der wenigstens einen Störinformation (40),

   **dadurch gekennzeichnet, dass** in Schritt (iii) zum Ermitteln der wenigstens einen Störinformation (40) eine Modellierung des wenigstens einen Störfeldes (33) unter Verwendung der wenigstens einen Messinformation (38) erfolgt, wobei zur Modellierung ein ein Vektorfeld beschreibendes Feldmodell für das wenigstens eine Störfeld (33) verwendet wird.

2. Verfahren nach Anspruch 1, **dadurch gekennzeichnet, dass** die Magneteinrichtung (20) wenigstens eine Hauptfeldspule (21) und wenigstens eine Gradientenspulenanordnung (22) umfasst, wobei in Schritt (i) in dem Aufnahmebereich (12) ein, insbesondere wenigstens näherungsweise homogenes, Hauptmagnetfeld mittels der wenigstens einen Hauptfeldspule (21) und wenigstens ein Gradientenfeld mittels der wenigstens einen Gradientenspulenanordnung (22) erzeugt wird.

3. Verfahren nach Anspruch 1 oder 2, **dadurch gekennzeichnet, dass** in Schritt (ii) mittels des Magnetsensors (30) oder mittels jedem der Magnetsensoren (30) die einen Magnetvektor darstellende Messinformation (38) erfasst wird, wobei der Magnetvektor insbesondere drei skalare Werte umfasst, die jeweils die Stärke des Streumagnetfeldes bezüglich einer kartesischen Raumrichtung (17, 18, 19) betreffen.

4. Verfahren nach einem der vorangehenden Ansprüche, **dadurch gekennzeichnet, dass** der wenigstens eine in Schritt (ii) verwendete Magnetsensor (30) an einer Wand oder einer Decke oder einem Fußboden, insbesondere in einer Ecke, eines Raumes (31), in dem sich die Magnetresonanzeinrichtung (10) befindet, angeordnet ist.

5. Verfahren nach einem der vorangehenden Ansprüche, **dadurch gekennzeichnet, dass** in Schritt (iii) anhand der wenigstens einen Messinformation (38) wenigstens eine bereinigte Messinformation (39) ermittelt wird, die das außerhalb des Aufnahmebereichs (12) vorliegende und bezüglich des Einrichtungsmagnetfeldes (23) bereinigte Streumagnetfeld betrifft.

6. Verfahren nach Anspruch 5, **dadurch gekennzeichnet, dass** zur Ermittlung der wenigstens einen bereinigten Messinformation (39) Werte betreffend das bekannte Einrichtungsmagnetfeld (23) von Werten betreffend das Streumagnetfeld, die anhand der wenigstens einen Messinformation (38) vorliegen, subtrahiert werden.

7. Verfahren nach einem der vorangehenden Ansprüche, **dadurch gekennzeichnet, dass** das Feldmodell ein harmonisches Vektorfeld beschreibt und auf einer Funktionsentwicklung beruht, die räumlich harmonische Basisfunktionen, insbesondere bis maximal erster oder bis maximal zweiter Ordnung, umfasst, wobei

- das Feldmodell an die wenigstens eine, insbesondere bereinigte, Messinformation (38) gefittet wird, wobei die den Basisfunktionen des Feldmodells zugeordneten Koeffizienten als Fitparameter, die die wenigstens eine Störinformation (40) darstellen, verwendet werden, und/oder
- mittels des Feldmodells und der wenigstens einen, insbesondere bereinigten, Messinformation (38) ein lineares Gleichungssystem aufgestellt und gelöst wird, wobei die den Basisfunktionen des Feldmodells zugeordneten Koeffizienten die Unbekannten des Gleichungssystems sind, die die wenigstens eine Störinformation (40) darstellen.

8. Verfahren nach einem der vorangehenden Ansprüche, **dadurch gekennzeichnet, dass** das wenigstens ein Feldmodell mehrere separate, insbesondere orthogonale, Teilmodelle umfasst, wobei insbesondere vorgesehen ist, dass zum Ermitteln der wenigstens einen Störinformation (40) nur ein eine Hauptfeldrichtung der Magnetresonanzeinrichtung (10) betreffendes Teilmodell verwendet wird.

9. Verfahren nach einem der vorangehenden Ansprüche, **dadurch gekennzeichnet, dass** wenigstens eine Vergleichsinformation (32) betreffend eine zeitliche Entwicklung der wenigstens einen Messinformation (38) während des Auftretens eines Vergleichsstörfeldes (34) gespeichert wird, wobei bei dem späteren Auftreten eines weiteren Störfeldes (33), dessen zeitliche Entwicklung dem Vergleichsstörfeld (34) entspricht, die wenigstens eine Vergleichsinformation (32) im Rahmen des Schritts (iii) zur Durchführung eines Plausibilitätsabgleichs verwendet wird.

10. Verfahren nach einem der vorangehenden Ansprüche, **dadurch gekennzeichnet, dass** in Schritt (iv) das Kompensieren oder Reduzieren des wenigstens einen Störfeldes (33) in dem Aufnahmebereich (12) dadurch erfolgt, dass ein mittels wenigstens einer oder der wenigstens einen Gradientenspulenanordnung (22) der Magneteinrichtung (20) generierter Anteil des in dem Aufnahmebereich (12) vorhandenen Magnetfeldes mit einer, insbesondere zeitabhängigen, Magnetfeldänderung beaufschlagt wird, die anhand der wenigstens einen Störinformation (40) vorgegeben wird.

11. Verfahren nach Anspruch 10, **dadurch gekennzeichnet, dass** die wenigstens eine Gradientenspulenanordnung zwei Feldspulen (41) umfasst, die jeweils mittels einer separaten Stromquelle (42), die insbesondere ein Leistungsverstärker ist, zur Erzeugung des oder eines Gradientenfeldes derart bestromt werden, dass die Feldspulen (41) in einem Maxwell-Modus betrieben werden, wobei die im Rahmen des Maxwell-Moduls erfolgende Bestromung der Feldspulen (41) gegensinnig ausgeprägt ist und die Erzeugung des Gradientenfeldes bewirkt.

12. Verfahren nach Anspruch 11, **dadurch gekennzeichnet, dass** der im Rahmen des Maxwell-Modus erfolgenden Bestromung ein Gradientenoffset aufgeprägt wird, mittels dem ein linearer Anteil des Störfeldes (33) kompensiert oder reduziert wird, und/oder dass die Feldspulen (41) zusätzlich in einem Helmholtz-Modus betrieben werden, wobei die im Rahmen des Helmholtz-Modus erfolgende Bestromung der Feldspulen (41) gleichsinnig ausgeprägt ist und das Kompensieren oder Reduzieren eines konstanten Anteils des Störfeldes (33) bewirkt.

13. Magnetresonanzeinrichtung (10) zur Durchführung des Verfahrens nach einem der vorangehenden Ansprüche, wobei mittels der Magnetresonanzeinrichtung (10) eine Bildgebung zur Erfassung von Bilddaten (11) durchführbar ist, die ein Objekt (13) betreffen, das in einem Aufnahmebereich (12) der Magnetresonanzeinrichtung (10) angeordnet ist, wobei die Magnetresonanzeinrichtung (10) eine Magneteinrichtung (20) umfasst, mittels der ein in dem Aufnahmebereich (12) vorliegendes Einrichtungsmagnetfeld (23) erzeugbar ist, wobei ein tatsächlich in dem Aufnahmebereich (12) vorhandenes, gestörtes Magnetfeld aus dem Einrichtungsmagnetfeld (23) und wenigstens einem Störfeld (33) resultiert, wobei das Störfeld (33) von einem sich außerhalb des Aufnahmebereichs (12) befindenden Störobjekts (35) verursacht wird, wobei mittels wenigstens eines Magnetsensors (30), insbesondere der Magnetresonanzeinrichtung (10), wenigstens eine Messinformation (38) erfassbar ist, die ein außerhalb des Aufnahmebereichs (12) vorliegendes und aus dem Einrichtungsmagnetfeld (23) und dem wenigstens einen Störfeld (33) resultierendes Streumagnetfeld betrifft, wobei mittels einer Steuerungseinrichtung (25) wenigstens einer Störinformation (40) betreffend das wenigstens eine Störfeld (33) unter Verwendung der wenigstens einen Messinformation (38) ermittelbar ist, wobei die Steuerungseinrichtung (25) dazu eingerichtet ist, Steuersignale (28) derart zu generieren und an die Magnetresonanzeinrichtung (10) auszugeben, dass das wenigstens eine Störfeld (33) in dem Aufnahmebereich (12) mittels einer Änderung des Einrichtungsmagnetfeldes (23) unter Verwendung der wenigstens einen Störinformation (40) kompensierbar oder reduzierbar ist,

**dadurch gekennzeichnet,**

**dass** die Steuerungseinrichtung (25) dazu eingerichtet ist, zum Ermitteln der wenigstens einen Störinformation (40) eine Modellierung des wenigstens einen Störfeldes (33) unter Verwendung der wenigstens einen Messinformation (38) durchzuführen, wobei zur Modellierung ein ein Vektorfeld beschreibendes Feldmodell für das wenigstens eine Störfeld (33) verwendet wird.

14. Steuerungseinrichtung (25) für eine Magnetresonanzeinrichtung (10) nach Anspruch 13, umfassend eine Speichereinheit (26), auf der ein ausführbares Computerprogramm gespeichert ist, das dazu geeignet ist, durch eine Verarbeitungseinrichtung (27) der Steuerungseinrichtung (25) gelesen zu werden und hierbei die Verarbeitungseinrichtung (27) dazu zu veranlassen, die wenigstens eine Störinformation (40) betreffend das wenigstens eine Störfeld (33) unter Verwendung der wenigstens einen Messinformation (38) zu ermitteln und die Steuersignale (28) derart zu generieren und an die Magnetresonanzeinrichtung (10) auszugeben, dass das wenigstens eine Störfeld (33) in dem Aufnahmebereich (12) mittels einer Änderung des Einrichtungsmagnetfeldes (23) unter Verwendung der wenigstens einen Störinformation (40) kompensiert oder reduziert wird.

15. Speichereinheit (26) für eine Steuerungseinrichtung (25) nach Anspruch 14, wobei auf der Speichereinheit (26) ein ausführbares Computerprogramm gespeichert ist, das dazu geeignet ist, durch eine Verarbeitungseinrichtung (27) der Steuerungseinrichtung (25) gelesen zu werden und hierbei die Verarbeitungseinrichtung (27) dazu zu veranlassen, die wenigstens eine Störinformation (40) betreffend das wenigstens eine Störfeld (33) unter Verwendung der wenigstens einen Messinformation (38) zu ermitteln und die Steuersignale (28) derart zu generieren und an die Magnetresonanzeinrichtung (10) auszugeben, dass das wenigstens eine Störfeld (33) in dem Aufnahmebereich (12) mittels einer Änderung des Einrichtungsmagnetfeldes (23) unter Verwendung der wenigstens einen Störinformation (40) kompensiert oder reduziert wird.

## FIG 1

FIG 2

EP 4 733 794 A1

**FIG 3**

FIG 4

## FIG 5

## FIG 6

**EUROPÄISCHER RECHERCHENBERICHT**

Europäisches Patentamt
European Patent Office
Office européen des brevets

Nummer der Anmeldung

EP 24 20 8862

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | US 2018/031651 A1 (IAIA PAOLO [IT]) 1. Februar 2018 (2018-02-01) | 1-4,7,8, 10-15 | INV. G01R33/389 |
| A | * das ganze Dokument * | 5,6,9 | G01R33/565 G01R33/54 |
| | ----- | | |
| X | EP 1 582 886 B1 (UNIV ZUERICH [CH]; ETH ZUERICH ETH TRANSFER [CH]) 15. August 2012 (2012-08-15) | 1-4,7,8, 10-15 | |
| A | * Absätze [0003], [0010] - [0016], [0025], [0035] - [0043]; Anspruch 1 * | 5,6,9 | |
| | ----- | | |
| A | US 5 214 383 A (PERLMUTTER ROBERT J [US] ET AL) 25. Mai 1993 (1993-05-25) * das ganze Dokument * | 1-15 | |
| | ----- | | |
| A | US 2021/063516 A1 (CONNELL IAN [CA] ET AL) 4. März 2021 (2021-03-04) * Absatz [0037] - Absatz [0040]; Abbildungen 1-3 * | 1-15 | |
| | ----- | | |

**RECHERCHIERTE SACHGEBIETE (IPC)**

G01R

Der vorliegende Recherchenbericht wurde für alle Patentansprüche erstellt

| Recherchenort | Abschlußdatum der Recherche | Prüfer |
|---|---|---|
| München | 8. April 2025 | Faber-Jurk, Sonja |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument
.......................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**                     EP 24 20 8862

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

08-04-2025

| Im Recherchenbericht angeführtes Patentdokument | Datum der Veröffentlichung | Mitglied(er) der Patentfamilie | Datum der Veröffentlichung |
|---|---|---|---|
| US 2018031651 A1 | 01-02-2018 | EP 3276366 A1 <br> US 2018031651 A1 | 31-01-2018 <br> 01-02-2018 |
| EP 1582886 B1 | 15-08-2012 | EP 1582886 A1 <br> US 2005218892 A1 | 05-10-2005 <br> 06-10-2005 |
| US 5214383 A | 25-05-1993 | KEINE | |
| US 2021063516 A1 | 04-03-2021 | CA 3091883 A1 <br> GB 2589702 A <br> US 2021063516 A1 <br> US 2021318399 A1 | 03-03-2021 <br> 09-06-2021 <br> 04-03-2021 <br> 14-10-2021 |

EPO FORM P0461

Für nähere Einzelheiten zu diesem Anhang : siehe Amtsblatt des Europäischen Patentamts, Nr.12/82

**IN DER BESCHREIBUNG AUFGEFÜHRTE DOKUMENTE**

**In der Beschreibung aufgeführte Patentdokumente**

- EP 4369017 A1
- EP 4105671 A1
- US 11953572 B2
- US 11815575 B2